# EUROPEAN PATENT APPLICATION

(11) **EP 2 924 883 A1**
(43) Date of publication of application: **30.09.2015**
(21) Application number: 14290077.8
(22) Date of filing: 26.03.2014
(51) Int. Cl.: H03M 13/37, H04W 76/02, H04L 12/707, H04L 12/801

(54) **A telecommunications method, telecommunications system, node and user equipment**

(71) Applicant: ALCATEL LUCENT, 92100 Boulogne-Billancourt (FR)
(72) Inventor: Razavi, Rouzbeh, 15 Dublin (IE); Claussen, Holger, 15 Dublin (IE)
(74) Representative: Lichota, Catherine Margaret Timmis

(57) **Abstract**

A telecommunications method for a telecommunications system (102) comprising a plurality of nodes (104, 106, 110, 112, 114; 902; 1002), the plurality of nodes (104, 106, 110, 112, 114; 902; 1002) including a first node (106) (e.g. an end server, such as a web server) and a second node (104) (e.g. a user equipment, such as a smartphone, tablet or other PDA With multiple radio access devices), a plurality of said nodes being wireless nodes (104, 110, 112, 114; 902; 1002). The method comprises: transmitting first data from the first node (106); and receiving second data at the second node (104); wherein a path (116, 118, 120) between the first node (106) and the second node (104) includes at least one wireless segment (116b, 118b, 120b). In said wireless segment (116b, 118b, 120b), a first wireless node (104) is adapted for concurrent communication with at least a second wireless node (110) and a third wireless node (112), the second wireless node (110) and a third wireless node (112) being based on different wireless communications technologies (e.g. a cellular wireless and a IEEE 802.11-compliant wireless). The method further comprises transmitting, using one or both of said second wireless node (110) and said third wireless node (112), rateless coded data therefrom to the first wireless node (104), the rateless coded data comprising or corresponding to said first data. The rateless coded data comprising or corresponds to said source data, depending whether encoding to rateless data packets is performed at the source server (106) or wireless nodes(110, 112, 114; 902; 1002). A telecommunications system (102), an end server (106), a wireless basestation node (110, 112, 114; 902; 1002), and a user equipment (104) are also disclosed.

## Description

### FIELD OF THE INVENTION

The present invention relates to a telecommunications method for a telecommunications system comprising a user equipment in concurrent connection with multiple nodes, a telecommunications system, a node and to a user equipment.

### BACKGROUND OF THE INVENTION

Telecommunications systems based on networks of nodes are well established, with the "final" node connected to user equipment (UE; e.g. a handheld device) comprising or incorporating a base-station (defining a corresponding macrocell, Small Cell, etc.), for example one communicating wireless via a form of Radio Access Technology (RAT). Of late, multi-RAT base-stations are becoming very common. For example, a wide range of future base station products are expected to have integrated Wi-Fi (IEEE 802.11-compliant) radio. In addition, in most areas, users are covered by multiple access technologies (private Wi-Fi, public Wi-Fi, UMTS, LTE, etc.). This is in line with the growth of smartphone and tablet devices which are normally equipped with multiple wireless access technologies. Such multi-RAT systems can provide the ability to transmit data packets over multiple link paths, and offer a number of benefits such as enhanced wireless network capacity and wireless link reliability.

In addition, when using multiple RATs, service disruption/degradation when user is performing handover on a particular access technology is minimised. The advantage of exploiting capabilities of multi-RAT systems becomes even more significant when considering small cell base-stations which normally serve only few users at a time, leaving some of the radio interfaces unused. However, the challenging issue is to optimally distribute traffic (packets) onto multiple link paths over heterogeneous wireless access networks, particularly if they are not under the control of a single network provider. In fact, the potential gains of deploying multi-RAT systems will only be realised when appropriate and efficient algorithms capable of managing the whole pool of available radio resources are utilised. In this context, the concept of Common Radio Resource Management (CRRM) was introduced by 3GPP which refers to a set of functions designed to ensure an efficient use of available radio resources in heterogeneous networks.

As a typical technique for link aggregation, round robin (RR) scheduling has been proposed. However, it is shown that RR is more suitable for homogeneous and stable links such as wired networks. On the other hand, weighted round robin (WRR) has been proposed for heterogeneous links, where the difference between link bandwidths is quite large. Despite of the fact that WRR may take into account the capacity difference between available links, there is still the need for accurate estimation of individual links capacity. Unfortunately, this cannot be realised efficiently when considering wireless links where the link quality is constantly varying over time due to interference, mobility, and fading effects.

Solutions such as RR scheduling propose to use intensive end-to-end feedback in order estimate quality of available links. However, despite of significant overhead as a result of such intensive feedback, the system may still perform poorly, as link variations of radio links normally occur at much shorter time intervals compared to the end-to-end latency of the network. In other words, such feedback information might become obsolete by the time they are received at the controller (end node). In addition, the solution requires UEs to constantly monitor and report quality of radio links for all available access technologies.

Finally, 3GPP-WLAN interworking is receiving increasing interest in 3GPP Release 12; however, the approach is limited to WLANs deployed and controlled by the operators only, which severely limits its applicability.

Thus, in relation to the issue of link aggregation and utilising multiple RATs for a single traffic stream, a problem is that existing algorithms are either too complex for practical realisation or perform poorly, making it impossible to exploit the advantages of multi-RAT systems.

The present invention seeks to provide a solution to this problem so as to allow seamless aggregation across multiple access technologies and/or across multiple network owners/operators.

### SUMMARY OF THE INVENTION

According to a first aspect of the invention, there is provided a telecommunications method for a telecommunications system comprising a plurality of nodes, the plurality of nodes including a first node and a second node, a plurality of said nodes being wireless nodes, the method comprising: transmitting first data from the first node; and receiving second data at the second node; wherein a path between the first node and the second node includes at least one wireless segment; wherein, in said wireless segment, a first wireless node is adapted for concurrent communication with at least a second wireless node and a third wireless node, the second wireless node and a third wireless node being based on different wireless communications technologies; and wherein the method further comprises transmitting, using one or both of said second wireless node and said third wireless node, rateless coded data therefrom to the first wireless node, the rateless coded data comprising or corresponding to said first data.

In one embodiment, the first node comprises an end server storing source data, and the method comprises converting, using a first conversion module at the end server, the source data into rateless coded data, wherein the first data comprises said rateless coded data.

In another embodiment, the first node comprises an end server storing source data, said first data comprises said source data, and the method comprises: receiving said first data at each of said second wireless node and said third wireless node; and converting, using a second conversion module at the or each of the second wireless node and the third wireless node connected, in use, to the first wireless node, said first data into said rateless coded data.

In a further embodiment, one of said wireless nodes comprises a multi-RAT wireless node, the multi-RAT wireless node incorporating at least said second wireless node and said third wireless node.

The second node may comprise said first wireless node, and said second data may comprise said rateless coded data.

In one embodiment, transmitting rateless coded data comprises transmitting the rateless coded data in a plurality of batches, each batch comprising N packets. Transmitting rateless coded data may comprise, for each batch, transmitting the rateless coded data continuously until receipt at said second wireless node or said third wireless node of a batch completion acknowledgement message from the first wireless node, the batch completion acknowledgement message indicating that N packets have been received by the first wireless node.

The method may further comprise forwarding, by said second wireless node or said third wireless node, said batch completion acknowledgement message to another node upon receipt thereof.

In one embodiment, the first wireless node includes at least two wireless transceivers, said at least two wireless transceivers being based on different wireless communications technologies. The second wireless node and the third wireless node may each include at least one wireless transceiver, the wireless transceivers of the second wireless nodes and the third wireless node being based on different wireless communications technologies. For example, the second wireless node may comprise a cellular wireless basestation and/or the third wireless node may comprise a IEEE 802.11-compliant wireless basestation.

In one embodiment, the first wireless node comprises mobile wireless user equipment.

According to a second aspect of the invention, there is provided a telecommunications system, comprising: a plurality of nodes, the plurality of nodes including a first node and a second node, a plurality of said nodes being wireless nodes; wherein the first node is adapted to transmit first data; and wherein the second node is adapted to receive second data; wherein a path between the first node and the second node includes at least one wireless segment; wherein, in said wireless segment, a first wireless node is adapted for concurrent communication with at least a second wireless node and a third wireless node, the second wireless node and a third wireless node being based on different wireless communications technologies; and wherein one or both of said second wireless node and said third wireless node is adapted to transmit rateless coded data to the first wireless node, the rateless coded data comprising or corresponding to said first data.

According to a third aspect of the invention, there is provided an end server for a telecommunications system, the telecommunications system comprising a plurality of nodes, the plurality of nodes including a first node, formed by the end server and a second node, a plurality of said nodes being wireless nodes; wherein the end server is adapted to transmit first data; and wherein the second node is adapted to receive second data; wherein a path between the end server and the second node includes at least one wireless segment; wherein, in said wireless segment, a first wireless node is adapted for concurrent communication with at least a second wireless node and a third wireless node, the second wireless node and a third wireless node being based on different wireless communications technologies; and wherein one or both of said second wireless node and said third wireless node is adapted to transmit rateless coded data to the first wireless node, the rateless coded data comprising or corresponding to said first data.

According to a fourth aspect of the invention, there is provided a wireless transmitter node for a telecommunications system, the telecommunications system comprising a plurality of nodes, the plurality of nodes including a first node and a second node, a plurality of said nodes being wireless nodes and including said wireless transmitter node; wherein the first node is adapted to transmit first data; and wherein the second node is adapted to receive second data; wherein a path between the first node and the second node includes at least one wireless segment; wherein in said wireless segment, a first wireless node is adapted for concurrent communication with at least said wireless transmitter node and a third wireless node, the wireless transmitter node and a third wireless node being based on different wireless communications technologies; and wherein the wireless transmitter node is adapted to transmit, alone or concurrently with said third wireless node; rateless coded data to the first wireless node, the rateless coded data comprising or corresponding to said first data.

According to a fifth aspect of the invention, there is provided a wireless receiver node for a telecommunications system, the telecommunications system comprising a plurality of nodes, the plurality of nodes including a first node and the second node, a plurality of said nodes being wireless nodes and including said wireless receiver node (104); wherein the first node is adapted to transmit first data; and wherein the second node is adapted to receive second data; wherein a path between the first node and the second node includes at least one wireless segment; wherein, in said wireless segment, the wireless receiver node is adapted for concurrent communication with at least a second wireless node and a third wireless node, the second wireless node and a third wireless node being based on different wireless communications technologies; wherein one or both of said second wireless node and said third wireless node is adapted to transmit rateless coded data to the wireless receiver node, the rateless coded data comprising or corresponding to said first data.

The wireless receiver node may be adapted to receive and decode rateless coded data received via one or both of said second wireless node and said third wireless node.

According to a sixth aspect of the invention, there is provided a computer program product operable when executed on a computer to perform the method of the above first aspect.

Embodiments of the invention involve using multiple radio access technologies simultaneously for a single traffic stream based on rateless codes. Rateless codes can provide an extremely high level of flexibility in a sense that a decoder would only require to receive some sufficient number of rateless encoded packets to decode the original data. According to embodiments, the receiver can decode a given N original packets upon reception of any *N* rateless encoded packets (although, in practice, a slight overhead, e.g. approximately 5% may be involved). This provides great flexibility when exploring multiple radio links simultaneously since the transmitter/ controller does not require any knowledge concerning quality or capacity of individual links.

According to embodiments of the invention, rateless encoded packets can be sent through all available radio interfaces and are combined at the receiver. As soon as enough encoded packets are received, the decoder can re-construct the data. In that sense, neither the transmitter nor the receiver need be concerned about the quality of individual radio links. In contrast to sending data packets sequentially where failed packets ought to be re-transmitted, with rateless codes, failed/erased packets can be simply ignored. The transmitter continuously sends rateless encoded packets until the decoder receive sufficient number of correct packets to reconstruct the data.

Another advantage of embodiments of the invention is that the system can be fully functional as long as only one of the uplink radio links is operational at a time. In this way, all available networks appear to the end user as one single, more capable and reliable network that can take advantage of all available network infrastructures, irrespective of technology and operator.

A further advantage of embodiments of the invention is that they enable seamless convergence of multiple access technologies and allow the user to benefit simultaneously from the capacity of multiple air interfaces.

Embodiments of the present invention are easy to implement at a UE - for example via an application download - without need for changing standards.

Embodiments of the present invention provide extensive flexibility, as no channel estimation is required when allocating traffic to different links, and the scheme can provide maximisation of users' throughput. The overall coding and decoding procedure is additionally very straightforward. Finally, embodiments according to the invention provide an effective way to overcome shortcomings of TCP as a transport protocol and can additionally provide data confidentiality and security as a consequence.

Further, when using embodiments of the present invention, service disruption/degradation during the handover of a user on one particular access technology is minimised, as the user may continue using other RATs to send/receive traffic during the handover interval. This can be a beneficial feature, as service disruptions during the handover is known to be a significant concern for operators when deploying small cells.

Further particular and preferred aspects of the invention are set out in the accompanying independent and dependent claims.

### BRIEF DESCRIPTION OF THE DRAWINGS

Some embodiments of the apparatus and/or methods in accordance with embodiments of the present invention are now described, by way of example only, with reference to the accompanying drawings, in which:
Figure 1 shows a telecommunications network according to an embodiment of the invention;
Figure 2 shows a schematic block diagram of the end server in Fig. 1;
Figure 3 shows a schematic block diagram of the base station in Fig. 1;
Figure 4 shows a schematic block diagram of the user equipment in Fig. 1;
Figure 5 shows schematically the generation of rateless codes from source data;
Figure 6 shows schematically a comparison of the rateless coding transmission scheme according to the embodiment of Fig. 1 with TCP (with CWND=1) transmission;
Figure 7 shows a histogram of the actual number of rateless coded packets required to successfully decode a given number of original packets, for different rateless coding schemes;
Figure 8 shows results indicating the comparative performance of rateless code based transport and TCP, for a wired network scenario;
Figure 9 shows a telecommunications network according to a second embodiment of the invention; and
Figure 10 shows a telecommunications network according to a third embodiment of the invention.

### DESCRIPTION OF EMBODIMENTS

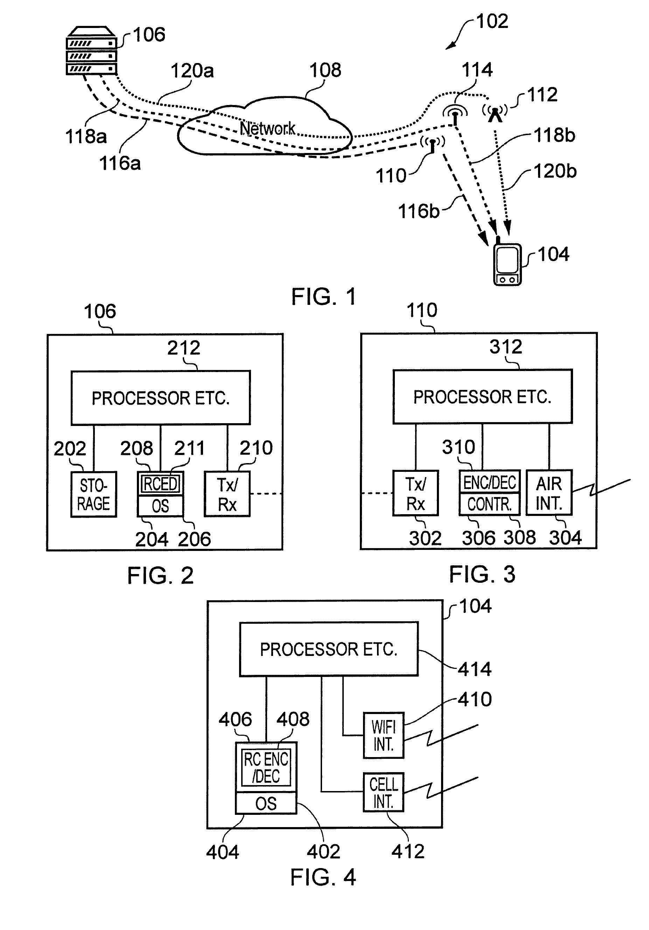

Figure 1 shows a telecommunications network 102 according to an embodiment of the invention.

In this embodiment, the telecommunication system 102 comprises user equipment 104 (such as a smartphone, PDA, or tablet computer), in communication with an end server 106 (also referred to herein as a source server) via a network 108, as is well known in the art. In this embodiment, user equipment 104 is coupled to a network via multiple connections, including a first connection 116a, 116b implemented via a Wi-Fi base station or node 110, a second connection 118a, 118b implemented via a cellular base station or node 114, and a third connection 120a, 120c via a further Wi-Fi base station or node 112. Thus, user equipment 104 is simultaneously coupled to base stations 110, 112 and 114 for receiving and sending data. It will be appreciated that user equipment 104 may, depending on the context, be concurrently connected to only two, or to greater than .3 basestations (nodes). In the embodiment of Fig. 1, basestations 110, 112 and 114 may be located in generally the same area/location, with overlapping cells, but controlled by different operators.

In this embodiment, each of the connections 116, 118 and 120 implements the transfer of data from the source server 106 to the user equipment 104 in the form of rateless codes, which will be discussed in further detail below. Here, rateless encoding is performed at the server side. Suitably, the techniques can be implemented as a stand-alone cloud service (operator independent).

In the above described example, the segment of the data path between end server 106 and user equipment 104 that is provided by the portions 116b, 118b and 120b of the connections 116, 118 and 120 is wireless. However, persons skilled in the art will appreciate that such a wireless segment may, in accordance with the invention, be provided between any multiplicity of (rateless code transmitting) nodes within the network 108 and a further (rateless code receiving) node, and that that wireless segment may be at any "point" in a data path over the network 108. Indeed the first node, the second node, or both, may be wireless nodes, and may be involved in the transfer of rateless coded data.

Figure 2 shows a schematic block diagram of the end server (source server 106) in Fig. 1. In Fig. 2, the source server 106, which is in a form well known in the art, is illustrated in simplified schematic form. In use, the source server 106 may transfer files, for example emails, data files, documents and HTML files (web pages),to the user equipment 104 upon request by the latter. Thus, the source server 106 may include a storage device 202 storage device storing local data/files, non-volatile memory 204, storing, in use, operating system software 206 and application software 208, as well as a transceiver 210, for example a network interface card for wired communications to the network 108. In accordance with the embodiments of the invention, the application software 208 may include a encoder/decoder software module 211 for converting files from storage 203 into rateless coded form (as discussed in further detail hereinafter) for a subsequent transmission by transceiver 210. The remaining circuitry of the source server 106 (which is well known in the art and not discussed here), is indicated at 212.

On the server side, the encoding and decoding (suitably by encoder/decoder software module 211) can be performed through proxy servers that are deployed in various data centres.

Figure 3 shows in simplified schematic form a base station or node 110 of Figure 1. (As used herein, "basestation" may be considered a node of the network, having a corresponding (macro or, as the case may be metro, small or other) cell (not shown). It will be appreciated that the node may comprise a basestation alone or incorporate it with other devices.)

The base station 110 may include a transceiver 302, for example a network interface card, for wired communications to the network 108. Base station 110 may also include analogue/digital conversion circuitry and an antenna (here referred to collectively as air interface 304) for wireless communication with the user equipment 104. (For this embodiment, air interface 304 comprises a Wi-Fi (IEEE 802.11-compliant) interface; for basestations 112 and 114, the air interface (not shown) comprises a cellular interface and a Wi-Fi interface, respectively.) However, it will be appreciated that, in each case the air interfaces may be based on other wireless protocols.

Preferably stored in non-volatile memory 306 are control software 308 as well as a rateless code encoded/decoder software module 310. Finally, the remaining circuitry of the base station 110 (which is well known in the art and not discussed here), is indicated at 312.

Figure 4 shows a schematic block diagram of the user equipment 104 in Fig. 1, in simplified schematic form. User equipment 104 may include non-volatile memory 402, storing operating system software 404 as well as application software 406, including a rateless code encoder/decoder software module 408. In this embodiment, user equipment 104 includes circuitry and an antenna collectively providing a Wi-Fi (i.e. 802.11) air interface 410, as well as circuitry and an antenna collectively providing a cellular communications interface 412. However, it will be appreciated that, in each case the air interfaces 410, 412 may be based on other wireless protocols, and more air interfaces may be included. As before, the remaining circuitry of the user equipment 104 (which is well known in the art and not discussed here), is schematically illustrated at 414.

Referring to Figures 1 and 2, in use, once connections 116, 118 and 120 have been established by the user equipment 104 with the source server 106, data from files at the source server 106 may be converted by the encoder/decoder software module 208 (Figure 2) and transmitted via transceiver 210 from source server 106; the transmitted data (constituting the source data in this embodiment) may thus be in rateless coded form, as discussed further below. In this case, UE 104 initiates multiple connections 116, 118, 120 through available links to the end servers 106. Encoded packets received from different links may then be combined at UE 104.

In this scheme, the rateless code encoder/decoder software module 408 may be an application that can be downloaded to user equipment 104. In addition, this application may continuously search for new air interfaces with access to the internet (e.g. known Wi-Fi hotspots where the user has access), and use all available ones.

The operation of the rateless code encoded/decoder software module 310 at basestation 110 will now be illustrated, by way of example (although it will be appreciated by persons skilled in the art that the exact sequence is not critical, and other methods or procedures may be used).

### Source server

A. Establish connection to user equipment via basestation 110
B. Establish connection to user equipment via basestation 112
C. Establish connection to user equipment via basestation 114
D. Receive request for date/file from user equipment
E. Access data/file
F. Commence and continue converting data/file into rateless code data
G. Group rateless code data into batches of N packets and commence transmission of batch
H. When Ack received from UE 104 that N packets received, commence transmission of next batch
I. Repeat F-H until all batches for data/file transmitted
J. Repeat E-I for the or each received request for date/file from user equipment

As regards action F, this is described in more detail as follows.

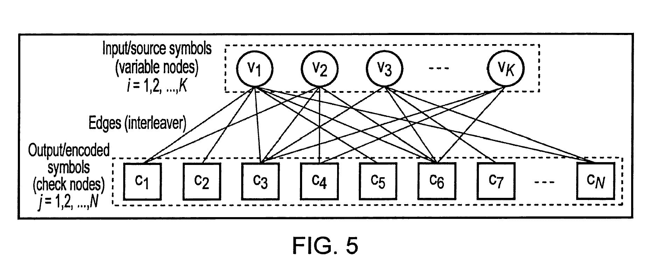

Figure 5 shows schematically the generation of rateless codes from source data, in one embodiment. Here there is outlined the principles of the encoding and decoding techniques of rateless coding for transmission over erasure channels. In this embodiment, Luby transform (LT) codes - the first practical realization of rateless Codes - are used, and the principles of the use of rateless codes according to embodiments of the invention will be explained with reference to those codes (whilst many other implementations/variants are possible in practice).

It is assumed that a data message (or file) consists of K input (source) symbols v = [v₁ v₂ ··· v_{K}], with each symbol containing an arbitrary number of bits. For the purposes of simplified illustration, a hypothetical example of a data message containing four two-bit symbols given by the vector v =[00 10 11 01] is considered.

Subsequently, the LT-encoded symbols c = [cⱼ],2 j = 1, ..., N, are each the modulo-2 sum (i.e., the eXclusive OR (XOR)) of d_{c} distinct input symbols, chosen uniformly at random. The actual d_{c}-value of each symbol to be encoded may then be chosen from a pre-defined distribution f(d_{c}), which is also sometimes referred to as the output distribution. It is assumed that the first dc-value sampled from f(d_{c}) is 2. Consequently, two input symbols may be chosen at random from v. It is assumed further that the two selected source symbols correspond to the first and second symbol in v. In such a case, c₁ may be calculated as 00 ⊗ 10 = 10, where "⊗" denotes the XOR function.

Encoding can proceed in the same manner, that is, each time selecting a d_{c}-value sampled pseudo-randomly from f(d_{c}) and then calculating the encoded symbol according to the XOR product of a dc-number of pseudo-randomly selected source symbols. Encoded symbols are sometimes referred to as "LT-encoded packets" due to the natural applicability of LT codes to the communication channels.

Referring to Fig. 5, the connection between the input and output symbols can also be diagrammatically represented by means of a bipartite graph. Using graph-related terminology, the input source symbol may be referred to as a variable node, while the LT-encoded symbol can be regarded as a check node. The number of edges emerging from each check node corresponds to the dc-value sampled from f(d_{c}) and for this reason, d_{c} is sometimes referred to as the check degree.

The operation of the rateless code encoded/decoder software module 310 at basestation 110 will now be illustrated, by way of example (although it will be appreciated by persons skilled in the art that the exact sequence is not critical, and other methods or procedures may be used).

### Basestation

i. Establish connection to source server 106
ii. Establish connection to user equipment 104
iii. Forward received request for date/file from user equipment to source server 106
iv. Receive rateless code data as batches of N packets and commence transmission to user equipment 104
v. When Ack received from UE 104 that N packets received, cease transmission of current batch and forward Ack to source server 106
vi. Repeat iv-v until all batches for data/file received and forwarded
vii. Repeat iv-vi for the or each received request for data/file from user equipment

The operation of the rateless code encoded/decoder software module 408 at user equipment 104, in particular for decoding of rateless codes, will now be illustrated, by way of example (although it will be appreciated by persons skilled in the art that the exact sequence is not critical, and other methods or procedures may be used).

### User Equipment

a) Establish connection to basestation 110
b) Establish connection to basestation 112
c) Establish connection to basestation 114
d) Send request for data/file to source server 106
e) Receive rateless code data via basestations 110, 112 and 114 concurrently
f) From rateless code data, convert batches of packets to reconstruct data/file
g) When N packets received (batch complete), send Ack signal to source server 106
h) Repeat e-g until all batches for data/file received
i) Repeat d-h for the or each request for date/file sent from user equipment 104.

As regards action f, this is described in more detail as follows.

An erasure channel is now considered, in which encoded symbols c are erased during the ensuing transmission. In an example, the decoder recovers erased symbols from unerased ones. The decoding process may commence by locating a degree-one input symbol; i.e., a symbol that is not XOR-combined with any other. The decoder may then modulo-2 add the value of this symbol to all the LT-encoded symbols relying on it and then remove the corresponding modulo-2 connections, where each connection may be represented by an edge on the associated bipartite graph (Fig. 5). The decoding procedure continues in an iterative manner, each time starting from a degree-one symbol.

### Rateless codes with Feedback

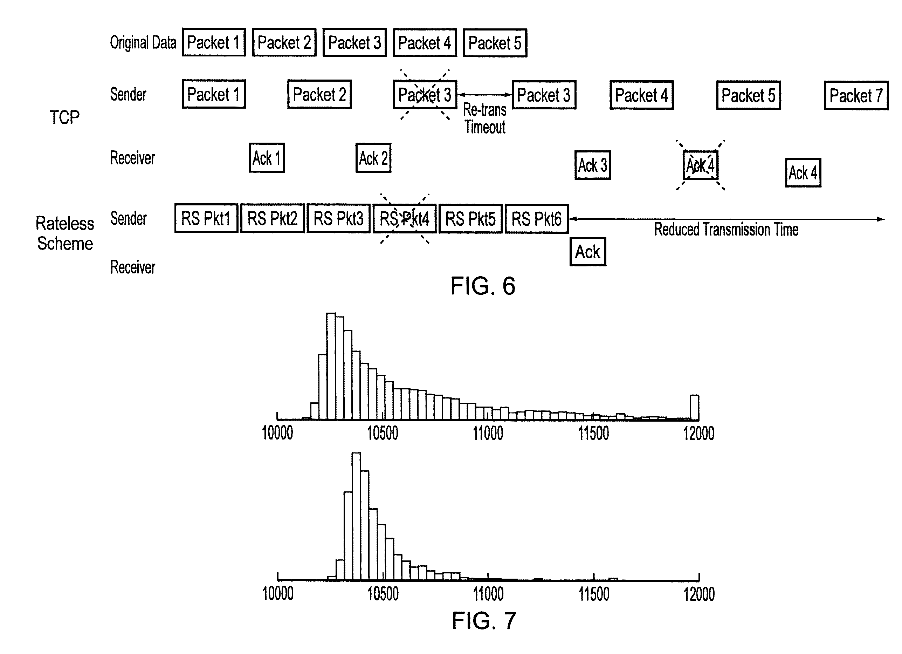

Figure 6 shows schematically a comparison of the rateless coding transmission scheme (lower part of Figure 6) according to the embodiment of Fig. 1 with TCP (with CWND=1 in this example; upper part of Figure 6) transmission.

According to the above described embodiment, any N original packets can be decoded using any N rateless coded packets with a high probability. In practice there may be a marginal overhead. Thus, the sender (source server 106) need not retransmit a data packet that is dropped or received with uncorrectable errors (if error correction codes are in use). Instead, the sender (source server 106) may continue transmitting rateless coded packets until N packets are received. At this point, the receiver (user equipment 104) sends a single acknowledgment packet (Ack) to allow the sender (source server 106) to move on to the next group of packets. This can significantly improve the latency of the transmission compared to the TCP (especially under congestion conditions when TCP congestion window is small).

In accordance with embodiments of the invention, a single node (e.g. basestation 110; see Fig. 1) receives the acknowledgement (Ack) packet. Embodiments of the invention provide that the Ack packet is forwarded to multiple further nodes, including for example to wireless basestation 112 and to wireless basestation 114; the latter may then cease transmitting the corresponding batch of packets.

In the rateless coding scheme, firstly, the number of packets involved in each batch may be decided and communicated with the receiver (user equipment 104). This rateless code based transport protocol may be similar to the UDP, in that the transmitter (source server 106) will send data packets consecutively. However, once enough correct packets are revived at the receiver side (user equipment 104), it sends an acknowledgment and the transmitter (source server 106) can move on to the next batch. If the size of the batch is changed, it is communicated to the receiver (user equipment 104). It should be noted that all rateless coded packets may contain mapping information in respect to the original packets. In Fig 5 for example, RS Pkt 1 might be result of the XOR operation of original packets 5 and 3. Since each batch of rateless coded packets covers a certain range of original packets, the receiver (user equipment 104) can easily tell which batch a received packet belongs to. Optionally, each packet may contain the batch ID.

Figure 7 shows a histogram of the actual number of rateless coded packets required to successfully decode a given number of original packets, for different rateless coding schemes. ue to the randomness aspect of the rateless coding, it is possible that some coded packets are duplicated or some specific packets are missing in a given number of coded packets. Therefore, in practice some overhead may be required in order to assure successful decoding of rateless coded packets. Fortunately, this overhead is marginal (1-8%). The actual overhead depends on the coding parameters. For example, with existing coding methods, it is possible to choose coding parameters such that the mean of the overhead is small with larger variance or instead using a strategy that has higher overheads on average but with lower variance. Referring again to Figure 7, the actual number of rateless coded packets required to successfully decode 10,000 original packets is indicated for two different coding strategies. The upper part of Figure 7 shows the case where the average number of required packets is smaller but the variance is higher; in the other scheme (lower,part of Fig. 7), the variance is lower, but a higher average number of required packets is involved.

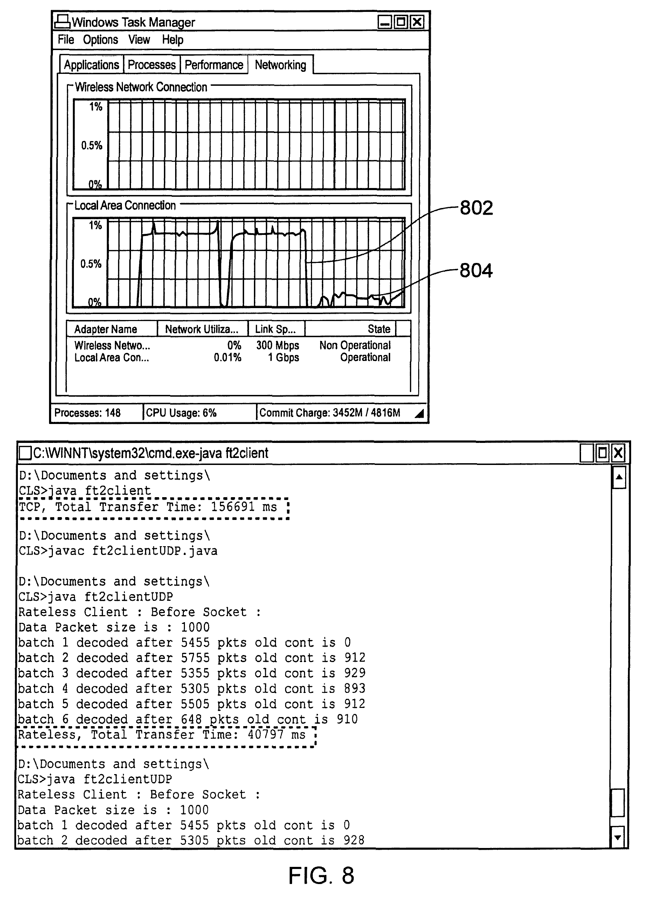

Figure 8 shows results indicating the comparative performance of rateless code based transport 802 and TCP based transport 804, for a wired network scenario. In this example, file transfer was used as a case study for comparison of throughput of the two schemes. To examine the feasibility and to evaluate the performance gains of the above described transport protocol, according to embodiments of the invention, based on rateless codes, a full end-to-end transport solution was implemented. Compared to the traditional TCP based transport 804, embodiments of the invention provide a throughput gain of about 4-times when considering wired links and up to 11-times when communication path consists of wireless links. For the wired network scenario, the results (lower part of Fig. 8, in dotted line boxes) indicate a 40797 ms transfer time for rateless, compared with 156691 ms for TCP.

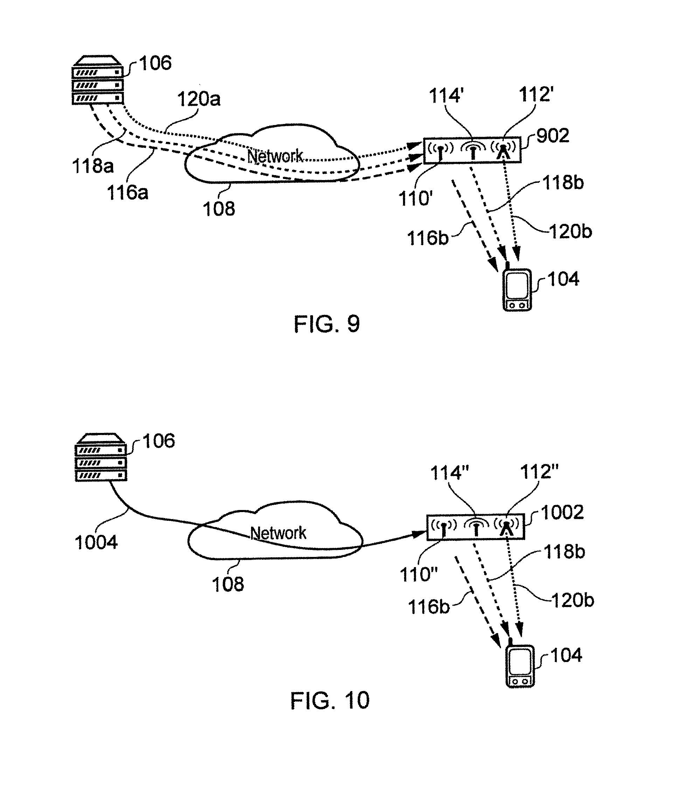

Figure 9 shows a telecommunications network according to a second embodiment of the invention. This is the same as the first embodiment, except as described as follows. In this embodiment, in place of basestations 110, 112 and 114 may be a multi-RAT (small cell) basestation 902, incorporating the functions (indicated as 110', 112' and 114') of basestations 110, 112 and 114 into a single unit. As before, the connections 116, 118, 120 may provide rateless code data transmission from source server 106 to user equipment 104, and the latter may have multiple (here 3) wireless links 116b, 118b, 120b to multi-RAT basestation 902. In this way, different access technologies, rather than being owned/controlled by different operators/owners, can be all integrated into a base-station controlled by a single operator.

Figure 10 shows a telecommunications network according to a third embodiment of the invention, suitable for network operator implementation. This is the same as the first embodiment, except as described as follows. In this embodiment, in place of basestations 110, 112 and 114 may be a multi-RAT (small cell) basestation 1002, incorporating the functions (indicated as 110", 112" and 114") of basestations 110, 112 and 114 into a single unit.

In this embodiment, data (source data) may be transmitted from source server 106 to multi-RAT basestation 1002 via conventional TCP link 1006 rather than separate rateless coded links 116a, 118a, 120a. At multi-RAT basestation 1002, the source data is converted to rateless code data in the manner described with respect to the encoder/decoder software module 211 of Fig. 2. Thus, as before, the user equipment 104 may have multiple (here 3) wireless links 116b, 118b, 120b to multi-RAT basestation 902 for receipt of rateless code data transmission from the multi-RAT basestation 1002.

In the embodiments of Figs 1 and 9, the rateless encoding and decoding at the server side was performed either by the server itself (source server 106) or through proxies. However, this functionality can be implemented in the base-station 1002 which is equipped with multiple air interfaces. Fortunately, rateless encoding (and decoding) are extremely straightforward, meaning that no computational burden is introduced for the basestation 1002. Moreover, if no other user is being served, all radio links 116b, 118b, 120b can be fully utilised. In general, if needed, a rate control algorithm may control the amount of data injected into each radio link. Once the UE receives sufficient number of packets, it can send an acknowledgment to the basestation 1002. It is only enough that the basestation 1002 receives one ACK packet from all available radio links.

Embodiments of the present invention seamlessly converge all available networks and give the end-user the experience of "one single network". All links may be utilized automatically dependent on availability. Embodiments of the invention are easy to implement via an application download at the UE 104 side and do not require any standards changes.

Embodiments of the present invention significantly boosts users' throughput and can additionally address all the problems associated to the TCP performance over wireless links. TCP's performance is very sensitive to packet losses and delayed packets. Specifically, the aggressive back-off behaviour of TCP may results in underutilisation of links and increased packets delay. A very recent study suggests a possible 16-fold throughput improvement in networks by modifying TCP behaviour. In addition, when using embodiments of the invention, service disruption/degradation during the handover of a user on one particular access technology is minimised since the user may continue using other RATs to send/receive traffic during the handover interval. This can be a differentiator feature since service disruptions during the handover is known to be a significant concern for operators when deploying small cells.

Finally, security and data privacy is another advantage of using rateless codes, according to embodiments of the invention. Essentially, rateless encoded packets cannot be decoded unless the exact mapping of the encoded packets to the original packets is known. In embodiments of the present invention, the mapping is communicated to the decoder using a secure mechanism (e.g. by securely exchanging a seed for a random generator); thus, data confidentially can be guaranteed as a byproduct of using embodiments of the present invention.

A person of skill in the art would readily recognise that steps of various above-described methods can be performed by programmed computers. Herein, some embodiments are intended to cover program storage devices, e,g, digital data storage media, which are machine or computer readable, and encode machine executable or computer-executable programs of instructions where said instructiosn perform some or all of methods described herein. The program storage devices may be, e.g., digital memories, magnetic storage media such as magnetic disks or tapes, hard drives or optically readable digital data storage media. The embodiments are also intended to cover computers programmed to perform said steps of methods described herein.

While the "modules" referred to herein for performing steps of various above-described methods are described as software modules, it will be appreciated by persons skilled in the that these may be implemented in practice alternatively by means of hardware, or by a combination of software and hardware.

The present inventions may be embodied in other specific apparatus and/or methods. The described embodiments are to be considered in all respects as only illustrative and not restrictive. In particular, the scope of the invention is indicated by the appended claims rather than by the description and figures herein. All changes that come within the meaning and range of equivalency of the claims are to be embraced within their scope.

## Claims

1. A telecommunications method for a telecommunications system (102) comprising a plurality of nodes (104, 106, 110, 112, 114; 902; 1002), the plurality of nodes (104, 106, 110, 112, 114; 902; 1002) including a first node (106) and a second node (104), a plurality of said nodes being wireless nodes (104, 110, 112, 114; 902; 1002), the method comprising:
transmitting first data from the first node (106); and
receiving second data at the second node (104);
wherein a path (116, 118, 120) between the first node (106) and the second node (104) includes at least one wireless segment (116b, 118b, 120b);
wherein, in said wireless segment (116b, 118b, 120b), a first wireless node (104) is adapted for concurrent communication with at least a second wireless node (110) and a third wireless node (112), the second wireless node (110) and a third wireless node (112) being based on different wireless communications technologies; and wherein the method further comprises
transmitting, using one or both of said second wireless node (110) and said third wireless node (112), rateless coded data therefrom to the first wireless node (104), the rateless coded data comprising or corresponding to said first data.

2. The telecommunications method as claimed in claim 1, wherein the first node (106) comprises an end server storing source data, and the method comprises converting, using a first conversion module (211) at the end server (106), the source data into rateless coded data, wherein the first data comprises said rateless coded data.

3. The telecommunications method as claimed in claim 1, wherein the first node (106) comprises an end server storing source data, said first data comprises said source data, and the method comprises
receiving said first data at each of said second wireless node (110) and said third wireless node (112);
converting, using a second conversion module (310) at the or each of the second wireless node (110) and the third wireless node (112) connected, in use, to the first wireless node (104), said first data into said rateless coded data.

4. The telecommunications method as claimed in claim 1, 2 or 3, wherein one of said wireless nodes (104, 110, 112, 114; 902; 1002) comprises a multi-RAT wireless node (902; 1002), the multi-RAT wireless node (902; 1002) incorporating at least said second wireless node (110) and said third wireless node (112).

5. The telecommunications method as claimed in any preceding claims, wherein the second node (104) comprises said first wireless node, and said second data comprises said rateless coded data.

6. The telecommunications method as claimed in any preceding claim, wherein transmitting rateless coded data comprises transmitting the rateless coded data in a plurality of batches, each batch comprising N packets.

7. The telecommunications method as claimed in claim 6, wherein transmitting rateless coded data comprises, for each batch, transmitting the rateless coded data continuously until receipt at said second wireless node (110) or said third wireless node (112) of a batch completion acknowledgement message from the first wireless node (104), the batch completion acknowledgement message indicating that N packets have been received by the first wireless node (104).

8. The telecommunications method as claimed in any preceding claim, further comprising forwarding, by said second wireless node (110) or said third wireless node (112), said batch completion acknowledgement message to another node (104, 106, 110, 112, 114; 902; 1002) upon receipt thereof.

9. The telecommunications method as claimed in any preceding claim, wherein
(a) the first wireless node (104) includes at least two wireless transceivers (304, 410, 412), said at least two wireless transceivers (304, 410, 412) being based on different wireless communications technologies; and/or
(b) the second wireless nodes (110) and the third wireless node (112) each include at least one wireless transceiver (304, 410, 412), the wireless transceivers (304, 410, 412) of the second wireless nodes (110) and the third wireless node (112) being based on different wireless communications technologies.

10. The telecommunications method as claimed in claim 9, wherein the first wireless node (104) comprises mobile wireless user equipment.

11. A telecommunications system (102), comprising:
a plurality of nodes (104, 106, 110, 112, 114; 902; 1002), the plurality of nodes (104, 106, 110, 112, 114; 902; 1002) including a first node (106) and a second node (104), a plurality of said nodes being wireless nodes (104, 110, 112, 114; 902; 1002);
wherein the first node (106) is adapted to transmit first data; and
wherein the second node (104) is adapted to receive second data;
wherein a path (116, 118, 120) between the first node (106) and the second node (104) includes at least one wireless segment (116b, 118b, 120b);
wherein, in said wireless segment (116b, 118b, 120b), a first wireless node (104) is adapted for concurrent communication with at least a second wireless node (110) and a third wireless node (112), the second wireless node (110) and a third wireless node (112) being based on different wireless communications technologies; and
wherein one or both of said second wireless node (110) and said third wireless node (112) is adapted to transmit rateless coded data to the first wireless node (104), the rateless coded data comprising or corresponding to said first data.

12. An end server (106) for a telecommunications system, the telecommunications system comprising a plurality of nodes (104, 106, 110, 112, 114; 902; 1002), the plurality of nodes (104, 106, 110, 112, 114; 902; 1002) including a first node, formed by the end server (106) and a second node (104), a plurality of said nodes being wireless nodes (104, 110, 112, 114; 902; 1002);
wherein the end server (106) is adapted to transmit first data; and
wherein the second node (104) is adapted to receive second data;
wherein a path (116, 118, 120) between the end server (106) and the second node (104) includes at least one wireless segment (116b, 118b, 120b);
wherein, in said wireless segment (116b, 118b, 120b), a first wireless node (104) is adapted for concurrent communication with at least a second wireless node (110) and a third wireless node (112), the second wireless node (110) and a third wireless node (112) being based on different wireless communications technologies; and
wherein one or both of said second wireless node (110) and said third wireless node (112) is adapted to transmit rateless coded data to the first wireless node (104), the rateless coded data comprising or corresponding to said first data.

13. A wireless transmitter node (110) for a telecommunications system (102), the telecommunications system (102) comprising a plurality of nodes (104, 106, 110, 112, 114; 902; 1002), the plurality of nodes (104, 106, 110, 112, 114; 902; 1002) including a first node (106) and a second node (104), a plurality of said nodes being wireless nodes (104, 110, 112, 114; 902; 1002) and including said wireless transmitter node (110);
wherein the first node (106) is adapted to transmit first data; and
wherein the second node (104) is adapted to receive second data;
wherein a path (116, 118, 120) between the first node (106) and the second node (104) includes at least one wireless segment (116b, 118b, 120b);
wherein in said wireless segment (116b, 118b, 120b), a first wireless node (104) is adapted for concurrent communication with at least said wireless transmitter node (110) and a third wireless node (112), the wireless transmitter node (110) and a third wireless node (112) being based on different wireless communications technologies; and
wherein the wireless transmitter node (110) is adapted to transmit, alone or concurrently with said third wireless node (112), rateless coded data to the first wireless node (104), the rateless coded data comprising or corresponding to said first data.

14. A wireless receiver node (104) for a telecommunications system (102), the telecommunications system (102) comprising a plurality of nodes (104, 106, 110, 112, 114; 902; 1002), the plurality of nodes (104, 106, 110, 112, 114; 902; 1002) including a first node (106) and the second node (104), formed by the user equipment, a plurality of said nodes being wireless nodes (104, 110, 112, 114; 902; 1002) and including said wireless receiver node (104);
wherein the first node (106) is adapted to transmit first data; and
wherein the second node (104) is adapted to receive second data;
wherein a path (116, 118, 120) between the first node (106) and the second node (104) includes at least one wireless segment (116b, 118b, 120b);
wherein, in said wireless segment (116b, 118b, 120b), the wireless receiver node (104) is adapted for concurrent communication with at least a second wireless node (110) and a third wireless node (112), the second wireless node (110) and a third wireless node (112) being based on different wireless communications technologies;
wherein one or both of said second wireless node (110) and said third wireless node (112) is adapted to transmit rateless coded data to the wireless receiver node (104), the rateless coded data comprising or corresponding to said first data.

15. A computer program product operable when executed on a computer to perform the method of any of claims 1 to 10.
